(19) Europäisches Patentamt
European Patent Office
Office européen des brevets

(11) Publication number: **0 389 236**
**A2**

(12) **EUROPEAN PATENT APPLICATION**

(21) Application number: **90302960.1**

(51) Int. Cl.5: **G03F 7/031, C08F 2/50**

(22) Date of filing: **20.03.90**

(30) Priority: **21.03.89 GB 8906470**

(43) Date of publication of application:
**26.09.90 Bulletin 90/39**

(84) Designated Contracting States:
**DE FR GB IT**

(71) Applicant: **COOKSON GROUP plc**
**130 Wood Street**
**London EC2V 6EQ(GB)**

(72) Inventor: **Coyle, John David**
**14 Highlands Close Chalfont St Peter**
**Buckinghamshire SL9 ODR(GB)**
Inventor: **Horton, Averil Myvanwy**
**21 The Hermitage**
**Richmond Surrey TW10 6SH(GB)**
Inventor: **Davidson, Robert Stephen**
**18 Enfield Cloisters, Fanshaw Street**
**London N1 6LD(GB)**
Inventor: **Bowser, Richard**
**79 Boxted Road, Hemel Hempstead**
**Herts HP1 2QW(GB)**
Inventor: **Moran, Patricia Mary**
**18 Graham Road, Harrow**
**Wealdstone, Middlesex HA3 5RP(GB)**

(74) Representative: **Allard, Susan Joyce et al**
**BOULT, WADE & TENNANT, 27 Furnival Street**
**London EC4A 1PQ(GB)**

(54) **Photopolymerisable composition.**

(57) A photopolymerisable composition comprising at least one ethylenically unsaturated polymerisable compound, at least one quinoxaline compound, and at least one triazine compound.

EP 0 389 236 A2

# PHOTOPOLYMERISABLE COMPOSITION

The invention relates to a photopolymerisable composition comprising ethylenically unsaturated polymerisable compounds, such as acrylates, which is useful for preparing photosensitive printing plates.

Photosensitive printing plates may be formed by providing a layer of a photopolymerisable composition on a suitable anodised aluminium sheet. The composition is polymerised by radiation. The radiation may be provided by an ordinary UV light source such as a metal halide lamp or by a mercury lamp. One source of visible radiation which has recently gained favour for polymerising such compositions is lasers which produce light of specific wavelengths within the range of 400-600nm e.g. an argon-ion laser which produces radiation of 488 nm.

Known compositions employed in photosensitive printing plates contain polymerisable compounds such as acrylates together with a polymerisation initiator. Various compounds are known as initiators. Many of the known initiators which are used contain at least one carbonyl group, for example, 3,3-carbonylbis(7-diethylaminocoumarin), Irgacure 184 (1-hydroxycyclohexyl phenyl ketone) and Irgacure 651 (benzil dimethylketal) marketed by Ciba Geigy. Exceptions to this are recently discovered trihalomethyl-substituted triazines such as those described in US 4330590, US 4189323, US 4258123, US 4481276 and EP 0271195A. Certain quinoxaline and alloxazine compounds have also been disclosed as photoinitiators in GB 1357367 and GB 2129953A.

While some of these known initiating compounds work well at certain wavelengths many are of limited use with the radiation of 488 nm which can be produced by an argon-ion laser. There is thus still a need for photopolymerisable compositions which can be effectively polymerised with radiation of 488 nm.

In accordance with the present invention there is provided a photopolymerisable composition comprising (a) at least one ethylenically unsaturated polymerisable compound, (b) at least one quinoxaline compound, and (c) at least one triazine compound.

The applicant has surprisingly found that when both a quinoxaline compound and a triazine compound are employed in a polymerisable composition that composition is sensitive to radiation of 488 nm and can easily be polymerised by such radiation. When either a quinoxaline or triazine is used alone in such a composition the sensitivity to radiation of 488 nm is very low.

Preferably component (b) will comprise a quinoxaline compound of the formula I or II

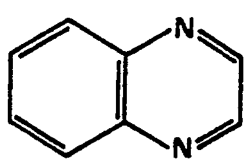

I

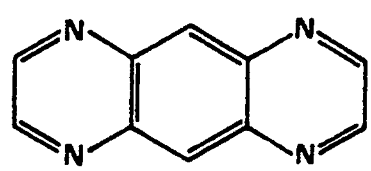

II

which may be substituted on the aromatic rings, or a salt thereof.

Examples of substituents which may be present on the aromatic rings of the quinoxaline compounds of formula I and II, include alkyl groups, aryl groups, alkenyl groups, aralkenyl groups, halogen atoms, carboxylate groups of formula $-COOR^5$ in which $R^5$ may be hydrogen or a $C_1$-$C_{12}$ alkyl group or an aryl group, and $-COR^6$ groups in which $R^6$ is hydrogen, an alkyl group or an aryl group. Aryl groups may be present either as substituents bonded to a single carbon atom on the aromatic rings or may contribute to the fused ring system by sharing a common carbon-carbon bond with one of the aromatic rings.

The term "alkyl group" as used herein includes substituted and unsubstituted alkyl groups and references to "aryl", "alkenyl" "aralkyl" and "aralkenyl" groups should be similarly construed.

Quinoxaline compounds which are particularly preferred for use in the present invention have at least one substituent which is an alkenyl or aralkenyl group which conjugates with the unsaturation of the quinoxaline ring system, an alkyl group or an aryl group. A styryl group is an example of an aralkenyl group which would conjugate with the quinoxaline ring system, while a 1,4 butadiene group is an example of an alkenyl group which would conjugate with the quinoxaline ring system. Most preferably at least one alkenyl or aralkenyl group will be substituted in a position adjacent to a nitrogen atom of the quinoxaline ring.

Specific examples of quinoxalines which may be employed in the present invention are

2,3-bis(4′-dimethylaminostyryl)quinoxaline,

2,3-bis(4′-diethylaminostyryl)quinoxaline,
2,3-bis(4′-dimethylaminophenylbuta 1,3-dienyl)quinoxaline,
2,3-bis(2′,4′,6′-trimethoxystyryl)quinoxaline,
2,3-bis(4′-methoxyphenylbuta-1,3-dienyl)quinoxaline,
2,3 bis(4′-carboxystyryl)quinoxaline,
2,3-diphenyl-6-benzoylquinoxaline,
2,3-dimethylquinoxaline, acenaphtho[1,2:b]quinoxaline,
phenanthroquinoxaline, 2,3-diphenylquinoxaline,
2,3-bis(styryl)quinoxaline,
6,6′-carbonylbis(2,3-diphenylquinoxaline),
2-phenyl-3-styrylquinoxaline, 2-benzoylquinoxaline,
2,3-dimethylbenzo[g]quinoxaline, 2,3-diphenylbenzo[g]quinoxaline, benzo[g]quinoxalino[2,3-1]phenanthrene, 7,12-dihydro-2,3-diphenylnaphtho[2,3-f]quinoxaline-7,12-dione, 2,3-dichloroquinoxaline, 2,3-bis(2-pyridyl)-quinoxaline, and 2,3,7,8-tetraphenylpyrazino[2,3-g]quinoxaline.

Examples of salts of quinoxaline compounds which may be employed in the present invention are 2,3-dimethyl-1-phenylquinoxalinium perchlorate and 2,3-dimethyl-1-hydroquinoxalinium perchlorate

Preferably component (c) will comprise a triazine compound of formula III

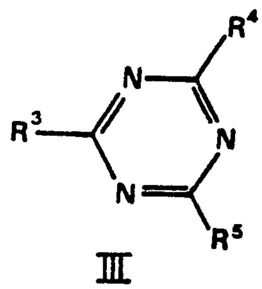

III

wherein $R^1$, $R^2$ and $R^3$ each independently represent a hydrogen atom, an alkyl group, an aryl group, an alkenyl group, or an aralkyl group, provided that at least one of $R^1$, $R^2$ and $R^3$ is a methyl group substituted with 1, 2 or 3 halogen atoms selected from chlorine and bromine.

Examples of substituted aryl groups which may be employed for $R^3$, $R^4$ or $R^5$ of the compound of formula III include trifluoromethylbenzyl, trifluoromethoxybenzyl, bromobenzyl, fluorobenzyl trifluoromethylthiobenzyl and alkoxybenzyl. Thus, for example, the triazines of the following formulae may be used 2-phenyl4,6 bis(trichloromethyl)-1,3,5-triazine, 2-(4-bromophenyl)-4,6-bis(trichloromethyl)-1,3,5-triazine, and 2 (4-trifluoromethylphenyl)-4,6-bis (trichloromethyl)-1,3,5-triazine.

Triazines of formula IV below which are described in EP 0271195A are particularly preferred for use in the composition of the present invention.

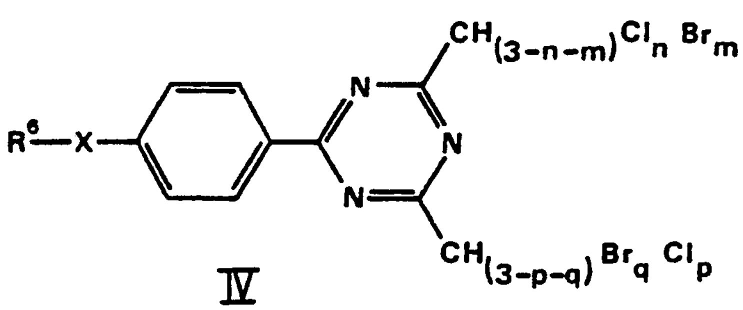

IV

wherein n, m, p and q are each independently 0, 1,2 or 3, the sum of n+m is not greater than 3, the sum of p+q is not greater than 3 and the sum of n+m+p+q is at least 1, X is a sulphur, selenium or tellurium atom and $R^6$ is an alkyl group or an aryl group.

Examples of triazines of formula IV include
2-(4-methylthiophenyl)-4,6-bis(trichloromethyl)-1,3,5-triazine,

2-(4-methylthiophenyl)-4,6-bis(tribromomethyl)-1,3,5-triazine,
2-(4-t-butylthiophenyl)-4,6-bis(trichloromethyl)-1-3-5-triazine,
2-(4-stearylthiophenyl)-4,6-bis(trichloromethyl)-1,3,5-triazine,
2-(4-ethylthiophenyl)-4,6-bis(trichloromethyl)-1,3,5-triazine and
2-(4-phenylthiophenyl)-4,6-bis(trichloromethyl)-1,3,5-triazine.

The component (a) of the present invention is provided by one or more ethylenically unsaturated polymerisable compounds, for example resins and acrylates such as acrylate or methacrylate monomers with di- or poly- functionality or acrylate or methacrylate polymers. Component (a) will preferably comprise one or more polymerisable acrylates. Examples of such acrylates are the polyester acrylates and dipentaerythritol pentaacrylate.

Preferably a binder will be included in the composition to improve its solidity and to reduce stickiness. The binder will normally be provided by a compound which does not take part in the polymerisation reaction but which provides bulk to the composition, for example cellulose acetate butyrate. If desired, a surfactant may also be included in the composition. A colourant may be included in the composition to improve the ease with which the composition can be seen. which the composition can be seen.

Conveniently component (b) and component (c) will each comprise 0.1 to 20 weight % of the composition. The total of component (a) and binder present will preferably be at least 80 weight %. Usually at least 30 weight % binder will be present.

Other co-initiating compounds may also be included in the composition if desired in addition to the quinoxaline and triazine. A co-initiator compound is a compound which when present in the composition together with the quinoxaline and triazine increases the sensitivity of the photopolymerisable composition to sensitising radiation compared with the sensitivity when quinoxaline and triazine alone are present. If employed in a photopolymerisable composition in the absence of other initiators a co-initiator may act as an initiator itself but it need not do so. Any known initiator compound may be employed as a co-initiator, for example, 3-(4-cyanobenzoyl)coumarin and 3,3-carbonylbis(7-diethylaminocoumarin). Examples of co-initiators which are not initiators themselves are ethyl carbon tetrabromide, triethanolamine, ethyl 4-dimethylaminobenzoate, 4-nitrobenzyl bromide and thiophenoxyacetic acid.

The present invention also provides a method of forming a photosensitive printing plate comprising (i) dissolving a photosensitive composition as described above in an organic solvent, such as oxitol or dimethylformamide, to form a solution, (ii) applying the solution of (i) to a substrate and then (iii) drying to form a layer of photosensitive composition on the substrate, and (iv) optionally applying a protective coating, for example a polyvinylalcohol coating, over the layer.

The use of a protective coating provides protection from atmospheric oxygen and thereby reduces the liklihood of inhibition of the polymerisation reaction by that oxygen. A surfactant is also preferably included in the coating.

Printing plates formed according to the invention may be exposed in a conventional manner for example with a print down frame using a silver photomask. Particularly favourably results are achieved using a scanning focussed beam such as that from an argon-ion laser.

Quinoxalines for use in the present invention may be produced for example by reaction of a bis-(bromomethyl)quinoxaline with triethyl phosphite and then reaction with an aromatic aldehyde in accordance with the process described in Synth. Commun. 1987, 638. For example:

<u>Preparation of 2,3-bis(2,4,6-trimethoxystyryl) quinoxaline</u>

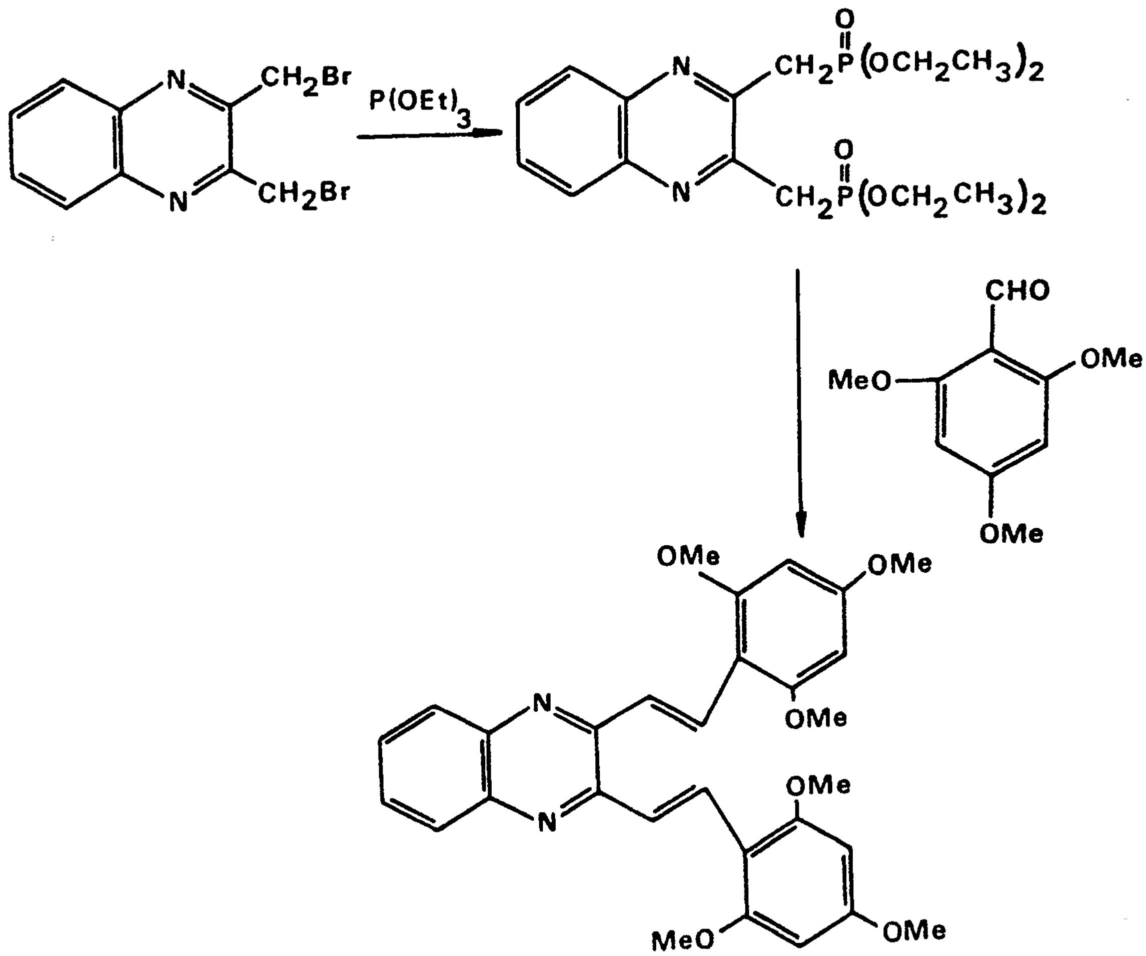


2,3-Bis(bromomethyl)quinoxaline (0.021 mol) is added to triethyl phosphite (0.26 mol) which is stirred at room temperature in a 500 ml flask with a thermometer and a distillation bridge, under the exclusion of moisture. The mixture is heated and at an initial temperature of 80 °C ethyl bromide distils rapidly. The resulting solution is heated to 140 °C for 3 hours. The excess of triethyl phosphite is distilled off under reduced pressure. By cooling to room temperature a tan coloured mass is obtained. This is recrystallised from ethyl acetate/hexane (1:2) to yield 2,3 bis(diethoxyphosphoniomethyl)quinoxaline. 0.01 mol of this product is refluxed with 2,4,6-trimethoxybenzaldehyde (0.022 mol) in ethanol (20 ml) with sodium (0.044 mol) for 2 hours. On cooling the product precipitates out and is recrystallised from ethyl acetate/hexane (1:1).

An alternative quinoxaline synthesis involves direct reaction of a bis(bromomethyl)quinoxaline with an amino substituted aromatic aldehyde. For example:

Preparation of 2,3-bis(4-diethylaminostyryl) quinoxaline

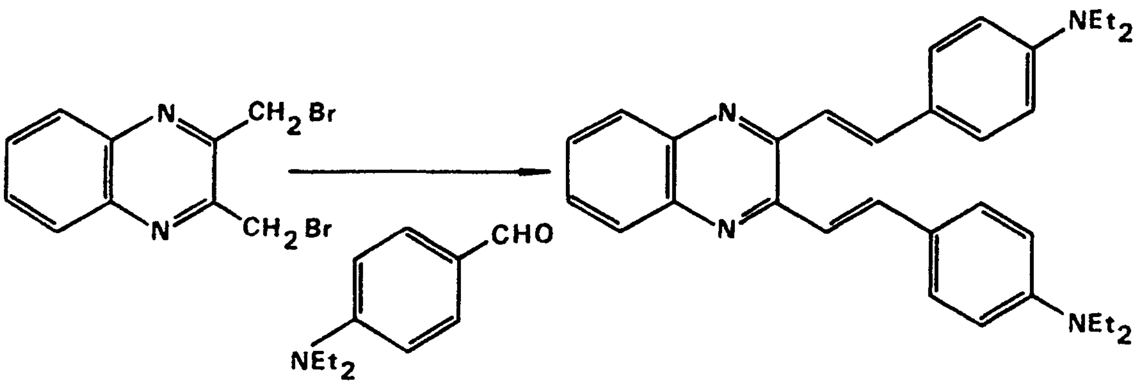

2,3-Bis(bromomethyl)quinoxaline (5 mmol) 4-diethylaminobenzaldehyde (12 mmol), sodium (25 mmol) and ethanol (30 $cm^3$) are refluxed for 30 minutes, cooled and left overnight at 0°C. The precipitate is filtered, washed with cold ethanol and recrystallised from ethyl acetate/petrol, b.p. 40-60°C (1:1).

Physical and analytical data for 2,3-bis(4-diethylaminostyryl)quinoxaline are given below.

appearance: bright orange crystals
mpt. 183-185°C
ir. (nujol mull) 1595, 1510, 1455 and 1370 $cm^{-1}$ nmr. $\delta$($CDCl_3$.60MHz) 8.1-7.2 (12H, complex, aromatic) 6.65 (4H,d,J 10Hz, CH=CH), 3.4 (8H, q, J 7Hz, N-$CH_2$-) and 1.2 (12H, t, J 7Hz, -$CH_3$).
elemental analysis:
Calculated for $C_{32}H_{36}N_4$ C 80.63; H 7.61, N 11.75, found C 79.50; H 7.78, N 11.57

Physical and analytical data for 2,3-bis(4-dimethylaminophenyl buta-1,3-dienyl)quinoxaline prepared in a similar way are given below.

appearance: bright red needles
mpt. 225-228°C
ir. (nujol mull) 1590, 1455 and 1370 $cm^{-1}$
nmr. $\delta$($CDCl_3$ 60MHz 8.0-6.6 (20H, complex, aromatic and CH=CH) and 3.0 (12H,s,Me)
elemental analysis:
Calculated for $C_{32}H_{32}N_4$ C 81.32; H 6.83; N 11.85, found C 79 34; H 6.90; N 11.34

Compositions according to the present invention are illustrated and compared with other compositions in the following examples.

## Example 1

A solution of photopolymerisable composition was formed by dissolving the following compounds in oxitol.

| | | |
|---|---|---|
| Component (a) | Ebecryl 810 (polyester acrylate, UCB chemicals) | 35% |
| | Sartomer SR 399 dipentaerythritol pentaacrylate, (Arco Speciality Chemicals) | 25% |
| Component (b) | 2,3-bis(4-dimethylaminostyryl) quinoxaline | 1% |
| Component (c) | 2-phenyl-4,6-bis (trichloromethyl)-1,3,5-triazine | 1% |
| Binder | Cellit BP900 (cellulose acetate butyrate, Bayer AG) | 38% |

The solution was applied to an anodised aluminium sheet and dried to leave a layer of photopolymerisable composition about 1µm thick on the sheet. A protective coating comprising 83 weight % Gohsenol KH17 (polyvinylalcohol) and 17 weight % Ethylan CPG660 (surfactant, Lankro) was then applied over the layer to protect it from inhibition by atmospheric oxygen.

The relative sensitivity to UV light of the photosensitive printing plate so produced was measured using a UV printdown frame.

The results are shown in Table I. For these results a higher number indicates greater sensitivity.

Comparative Examples 1 to 3

Example 1 was repeated using the same proportions of component (a) and binder but in each case the component (b) and component (c) were replaced with 1% each by weight of the compounds detailed in Table 1.

Comparative Examples 4 to 12

Example 1 was repeated but the amount of binder employed was increased to 39% by weight and the components (b) and (c) were replaced with 1% by weight of the compound detailed in Table 1. Irgacure 184 (1-hydroxycyclohexyl phenyl ketone) and Irgacure 651 (benzil dimethylketal) are initiators marketed by Ciba Ceigy.

Irgacure 184 and 651 and 4-4′-bis(diethylamino) benzophenone are known initiators which work well for some wavelengths of radiation but are not particularly effective with the UV radiation employed in these examples. The sensitivities of the compositions of Comparative Examples 1 to 14 containing triazine or quinoxaline alone or with another co-initiator are comparable to those of the compositions containing commercial Irgacure initiator or the known initiator 4,4′-bis(diethylamino)-benzophenone. The composition of Example 1 on the other hand which contains both quinoxaline and triazine is about 10 times more sensitive to this radiation.

Example 2 and Comparative Examples 13 to 15

Photosenstitive printing plates were prepared in the same way as in Example 1 using the same proportions of component (a) and binder. Components (b) and (c) were replaced with 1% each by weight of the compounds detailed in Table 2.

The sensitivity to 488nm light of the photosensitive printing plate so produced was measured using a focussed argon-ion laser and an appropriate light meter.

The results are shown in Table 2 in absolute units of mJ $cm^{-2}$. A lower number indicates a greater sensitivity.

Comparative Examples 16 to 19

Printing plates were prepared and tested in the same way as for Example 2 except that components (b) and (c) were replaced with 1% by weight of the compound detailed in Table 2 and 39 % by weight binder was used.

It can be seen from Table 2 that the compositions which contain only a quinoxaline or a triazine alone (in the absence of any other initiator or co-initiator compound) are insufficiently sensitive for practical purposes (registering off the scale as > 1000 mJ $cm^{-2}$) whereas Example 2 which contains both a quinoxaline and a triazine has a sensitivity which is comparable to that of the commercially very successful 3,3′-carbonyl bis(7-diethylaminocoumarin) (described in e.g. US4289844, GB 1578662 and EP 0022188).

Examples 3 to 25

Photosensitive printing plates were prepared and tested as in Example 2. Components (b) and (c) were replaced with 1% each by weight of a quinoxaline and triazine as detailed in Tables 3 to 6.

The sensitivity was measured as for Example 2. The results are shown in Tables 3 to 6 in absolute units of mJ $cm^{-2}$. A lower number indicates greater sensitivity.

Comparative Examples 20 to 23

Photosensitive printing plates were prepared and tested as in Example 2 but components (b) and (c) were replaced by 1% by weight of the shown quinoxaline compound and 39 wt. % of binder was used.

The results are shown in Tables 3 to 6 in mJ $cm^{-2}$. A lower number indicates greater sensitivity.

In Tables 3 to 6 the abbreviations stand for the following compounds:

| Chemical Name | Code Letter |
|---|---|
| 2-(4-methylthiophenyl)-4,6-bis(trichloromethyl)-1,3,5-triazine | A |
| 2-(4-methylthiophenyl)-4,6-bis(tribromomethyl)-1,3,5-triazine | B |
| 2-(4-t-butylthiophenyl)-4,6-bis(trichloromethyl)-1,3,5-triazine | C |
| 2-(4-stearylthiophenyl)-4,6-bis(trichloromethyl)-1,3,5-triazine | D |
| 2-(4-ethylthiophenyl)-4,6-bis(trichloromethyl)-1,3,5-triazine | E |
| 2-(4-phenylthiophenyl)-4,6-bis(trichloromethyl)-1,3,5-triazine | F |
| 2-phenyl-4,6-bis(trichloromethyl)-1,3,5-triazine | G |
| 2-(4-bromophenyl)-4,6-bis(trichloromethyl)-1,3,5-triazine | H |
| 2-(4-trifluoromethylphenyl)-4,6-bis(trichloromethyl)-1,3,5-triazine | I |

Comparative Examples 24 to 32

Compounds A to I when used to form photosensitive printing plates in an amount of 1 wt.% in place of components (b) and (c) in a composition of Example 1 containing 39 wt. % binder and measured using an argon-ion laser at 488 nm each give a sensitivity reading of > 1000 mJ $cm^{-2}$.

Table 1

| Example No. | Compound (b) | Compound (c) | Other initiator/ coinitiator | Relative sensitivity* |
|---|---|---|---|---|
| 1 | 2,3-bis(4-dimethyl-aminostyryl quinoxaline | 2-phenyl-4,6-bis(trichloromethyl)-1,3,5-triazine | - | 1476 |
| Comp.1 | phenanthrone quinoxaline | - | carbon tetrabromide | 538 |
| Comp.2 | 2,3-diphenyl quinoxaline | - | thiophenoxyacetic acid | 196 |
| Comp.3 | 2,3-bis(4-dimethyl-aminostyryl) | - | 4-nitrobenzylbromide | 36 |
| Comp.4 | - | - | 4,4'-bis(diethylamino) benzophenone | 100 |
| Comp.5 | - | - | Irgacure 184 | 9 |
| Comp.6 | - | - | Irgacure 651 | 36 |

Cont. on page 19

Table 1 continued

| Example No. | Compound (b) | Compound (c) | Other initiator/ coinitiator | Relative sensitivity* |
|---|---|---|---|---|
| Comp.7 | phenanthrone quinoxaline | - | - | 140 |
| Comp.8 | 2,3-diphenyl-quinoxaline | - | - | 71 |
| Comp.9 | 2,3,7,8-tetraphenylpyrazino[2,3-g] quinoxaline | - | - | 274 |
| Comp.10 | - | 2-phenyl-4,6-bis(trichloromethyl)-1,3,5-triazine | - | 140 |
| Comp.11 | - | - | carbon tetrabromide | 0 |
| Comp.11 | - | - | thiophenoxyacetic acid | 0 |

*Higher number represents greater sensitivity.

TABLE 2

| Example No. | Compound (b) | Compound (c) | Other initiator/ coinitiator | Sensitivity (mJ $cm^{-2}$)$^{+}$ |
|---|---|---|---|---|
| 2 | 2,3-bis(2,4,6-trimethoxystyryl) quinoxaline | 2-(methylthiophenyl) 4-6-bis(tri chloromethyl)-1,3,5-triazine | - | 143 |
| Comp.13 | 2,3-bis(2,4,6-trimethoxystyryl) quinoxaline | - | triethanolamine | > 1000 |
| Comp.14 | 2,3-bis(4-dimethyl-aminostyryl) quinoxaline | - | 4-nitrobenzylbromide | 163 |
| Comp.15 | 2,3-bis(2,4,6-trimethoxystyryl) | - | ethyl-4-dimethyl-aminobenzoate | 195 |

Cont. on page 21

Table 2 continued

| Example No. | Compound (b) | Compound (c) | Other initiator/ coinitiator | Sensitivity (mJ $cm^{-2}$)$^{+}$ |
|---|---|---|---|---|
| Comp.16 | - | | 3,3'-carbonylbis (7-diethylamino-coumarin) | 68 |
| Comp.17 | - | 2-phenyl-4,6-bis (trichloromethyl) -1,3,5-triazine | - | > 1000 |
| Comp.18 | 2,3-bis(4-dimethyl-aminostyryl) quinoxaline | - | - | > 1000 |
| Comp.19 | 2,3-bis(2,4,6-tri-methoxystyryl) quinoxaline | - | - | > 1000 |

+ Lower number indicates higher sensitivity

Table 3

| Compound (b) | | |
|---|---|---|
| 2,3-bis(4-diethylaminostyryl)quinoxaline | | |
| Example No. | Compound (c) | Sensitivity ($mJcm^{-2}$)+ |
| Comp 20 | - | >1000 |
| 3 | A | 8.5 |
| 4 | B | 12.2 |

+ Lower number indicates greater sensitivity

Table 4

| Compound (b) | | |
|---|---|---|
| 2,3-bis(4-dimethylaminostyryl)quinoxaline | | |
| Example No. | Compound (c) | Sensitivity $(mJcm^{-2})^{+}$ |
| Comp 21 | - | >1000 |
| 5 | A | 10 |
| 6 | B | 8.9 |
| 7 | E | 34 |
| 8 | F | 25 |
| 9 | C | 42 |
| 10 | D | 35 |
| 11 | G | 19 |
| 12 | H | 4 |
| 13 | I | 3 |

+ Lower number indicates greater sensitivity

Table 5

| Compound (b) | | |
|---|---|---|
| 2,3-bis(2,4,6-trimethoxystyryl)quinoxaline | | |
| Example No. | Compound (c) | Sensitivity ($mJcm^{-2}$)+ |
| Comp 22 | - | >1000 |
| 14 | B | 558 |
| 15 | A | 336 |
| 16 | F | 558 |
| 17 | D | 780 |
| 18 | E | 650 |
| 19 | C | 650 |

+ Lower number indicates greater sensitivity

Table 6

| Compound (b) | | |
|---|---|---|
| 2,3-bis(2,4,6-trimethoxyphenylbuta-1,4--dienyl)quinoxaline | | |
| Example No. | Compound (c) | Sensitivity ($mJcm^{-2}$)+ |
| Comp 23 | - | >1000 |
| 20 | A | 126 |
| 21 | B | 390 |
| 22 | F | 454 |
| 23 | E | 360 |
| 24 | D | 408 |
| 25 | C | 450 |

+ Lower number indicates greater sensitivity

## Claims

1. A photopolymerisable composition characterised by comprising (a) at least one ethylenically unsaturated polymerisable compound, (b) at least one quinoxaline compound, and (c) at least one triazine compound.

2. A composition as claimed in claimed 1 characterised in that the component (b) comprises a quinoxaline compound of the formula I or II

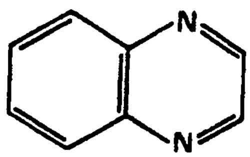

I

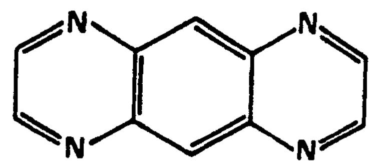

II

which may be substituted on the aromatic rings, or a salt thereof.

3. A composition as claimed in claim 1 or claim 2 characterised in that the component (c) comprises a triazine compound of formula III

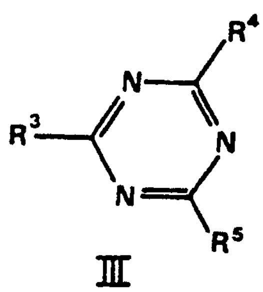

III

wherein $R^1$, $R^2$ and $R^3$ each independently represent a hydrogen atom, an alkyl group, an aryl group, an alkenyl group, or an aralkyl group, provided that at least one of $R^1$, $R^2$ and $R^3$ is a methyl group substituted with 1, 2 or 3 halogen atoms selected from chlorine and bromine.

4. A composition as claimed in claim 3 characterised in that the component (c) comprises a triazine compound of formula IV

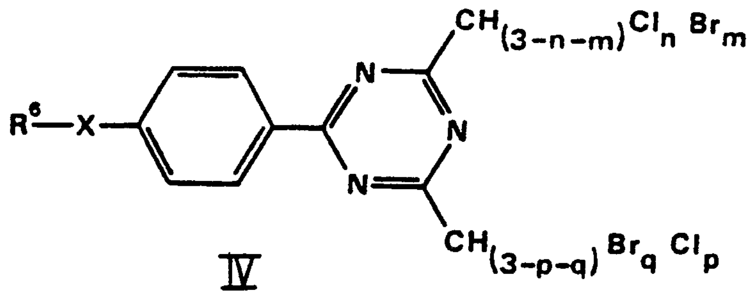

IV

wherein n, m, p and q are each independently 0, 1, 2 or 3, the sum of n+m is not greater than 3, the sum of p+q is not greater that 3 and the sum of n+m+p+q is at least 1, X is a sulphur, selenium or tellurium

atom and $R^6$ is an alkyl group or an aryl group.

5. A composition as claimed in any one of claims 1 to 3 characterised in that component (b) comprises a quinoxaline compound having at least one substituent which is an alkenyl or aralkenyl group which conjugates with the unsaturation of the quinoxaline ring system, an alkyl group or an aryl group.

6. A composition as claimed in any one of claims 1 to 4 characterised in that component (a) comprises one or more polymerisable acrylates.

7. A composition as claimed in any one of claims 1 to 4 characterised in that it further comprises a binder.

8. A method of forming a photosensitive printing plate characterised by (i) dissolving a photopolymerisable composition as claimed in any one of claims 1 to 7 in an organic solvent to form a solution, (ii) applying the solution to a substrate and then (iii) drying to form a layer of photopolymerisable composition on the substrate, and optionally (iv) applying a protective coating over the layer.

9. A photosensitive printing plate characterised by comprising a layer of a photopolymerisable composition as claimed in any one of claims 1 to 7.